# EUROPEAN PATENT SPECIFICATION

(11) **EP 2 660 985 B1**
(45) Date of publication and mention of the grant of the patent: **06.05.2015**
(21) Application number: 12765745.0
(22) Date of filing: 13.03.2012
(51) Int. Cl.: H04B 1/04, H01Q 23/00, H01Q 21/00, G02B 6/43

(54) **ACTIVE OPTICAL ANTENNA, MICROWAVE EMISSION SYSTEM AND METHOD FOR SENDING INFORMATION**
AKTIVE OPTISCHE ANTENNE, MIKROWELLENSTRAHLUNGSSYSTEM UND VERFAHREN ZUM SENDEN VON INFORMATION
ANTENNE OPTIQUE ACTIVE, SYSTÈME D'ÉMISSION DE MICRO-ONDES ET PROCÉDÉ D'ENVOI D'INFORMATIONS

(30) Priority: 25.03.2011 CN 201110074033
(43) Date of publication of application: 06.11.2013
(73) Proprietor: Huawei Technologies Co., Ltd., Longgang District Shenzhen, Guangdong 518129 (CN)
(72) Inventor: DONG, Limin, Shenzhen Guangdong 518129 (CN); LI, Kun, Shenzhen Guangdong 518129 (CN); CAI, Jun, Shenzhen Guangdong 518129 (CN)
(74) Representative: Pfenning, Meinig & Partner GbR
(86) International application number: PCT/CN2012/072250
(87) International publication number: WO 2012/130038

(56) References cited:
- WO-A2-2007/094944
- CN-A- 101 197 624
- CN-A- 101 420 270
- CN-A- 101 667 983
- CN-A- 101 715 249
- CN-A- 102 195 656
- JP-A- 2001 196 818
- JP-A- 2001 196 818
- US-A1- 2011 030 757

## Description

### FIELD OF THE INVENTION

The present invention relates to a communication system, and in particular to an active optical antenna, a microwave transmitting system and an information sending method.

### BACKGROUND OF THE INVENTION

Serving as a conventional communication manner, a microwave used to play an important role in the communications field. The microwave has inherent advantages such as simple deployment, low cost, and relatively far transport distance. With the continuous development of a communication network, the microwave still has a very wide application range, especially in the backhaul of a mobile base station and in a remote area with a complex terrain, where the microwave is giving play to its advantages and is widely applied. As transmit data traffic keeps growing, a conventional microwave frequency band is more and more crowded. To improve the transport bandwidth of the microwave, a new spectrum frequency band: 71-76 GHZ/81-86 GHZ, an E-band microwave (E-BAND), is found in the industry. The available bandwidth of this frequency band reaches 10 GHZ, which can meet a transport need of a high speed data service (such as GE/10 GE).

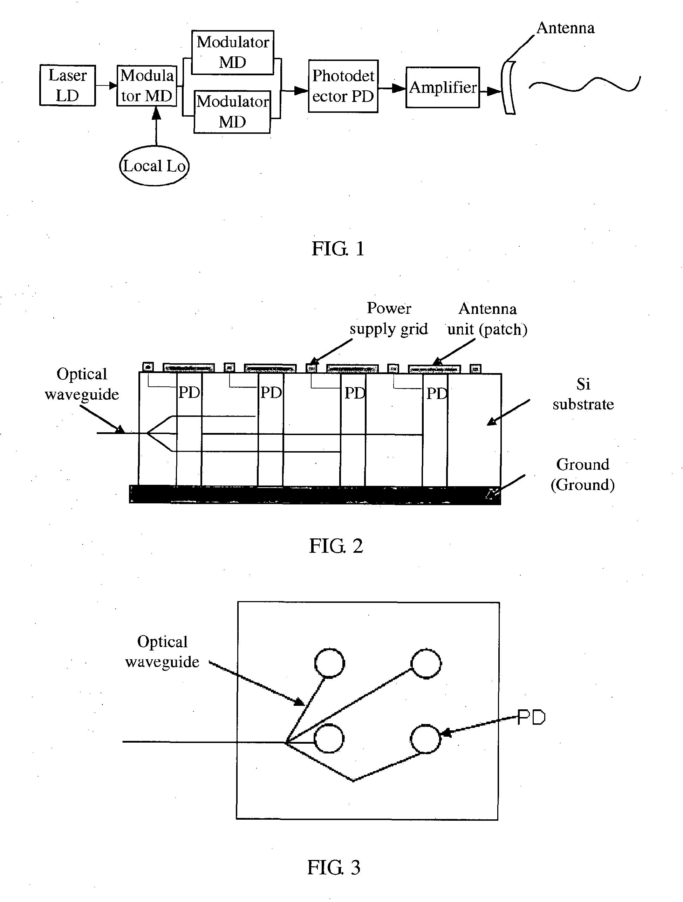

An existing method for implementing modulation of an intermediate frequency signal by using an optical modulator and thereby transmitting the signal is as shown in FIG. 1. In this embodiment, in a modulator (MD, Modulator), after local (LO, local) modulation is performed on a local modulation signal whose frequency is f/2, a laser (LD, laser diode) generates an optical carrier whose frequency difference is f. After modulation is performed by the modulator MD, where data is modulated onto the optical carrier, the optical carrier whose frequency difference is f forms a difference frequency optical signal, and then the difference frequency optical signal enters a photodetector (PD, Photodetector) tube, beat frequency is performed and a radio frequency signal is generated. The radio frequency signal is amplified by an amplifier and then is transmitted through an antenna. Generally, conversion output power of the PD tube is relatively low, and that the radio frequency signal obtained by the conversion performed by the PD tube directly enters the antenna often cannot meet a requirement of transmit power. Therefore, an amplifier needs to be added. However, an integration level of an antenna system is reduced and the costs of the antenna system are increased for every additional device.

JP 2001 196818 A discloses a ground electrode configuration capable of being produced by a simple process, easily entering light and being effectively operated as a ground surface in an antenna integrated element in which an optical signal is entered from the backside of a substrate.

WO 2007/094944 A2 discloses an antenna assembly comprising an antenna portion and an electrooptic waveguide portion. The antenna portion comprises at least one tapered slot antenna. The waveguide portion comprises at least one electrooptic waveguide. The electrooptic waveguide comprises a waveguide core extending substantially parallel to a slotline of the tapered slot antenna in an active region of the antenna assembly. The electrooptic waveguide at least partially comprises a velocity matching electrooptic polymer in the active region of the antenna assembly. The velocity ve of a millimeter or sub-millimeter wave signal traveling along the tapered slot antenna in the active region is at least partially a function of the dielectric constant of the velocity matching electrooptic polymer.; In addition, the velocity vo of an optical signal propagating along the waveguide in the active region is at least partially a function of the index of refraction of the velocity matching electrooptic polymer. Accordingly, the active region and the velocity matching electrooptic polymer can be configured such that ve and vo are substantially the same, or at least within a predetermined range of each other, in the active region. Additional embodiments are disclosed and claimed.

### SUMMARY OF THE INVENTION

An objective of embodiments of the present invention is to provide an active optical antenna, a microwave transmitting system and an information sending method to reduce the costs of the antenna and increase an integration level of the antenna.

An embodiment of the present invention provides an active optical antenna, including:
a substrate;
a ground disposed at the bottom of the substrate;
a power supply grid and several antenna units that are disposed at the top of the substrate, and photodetector tubes that are disposed in the substrate and located between the antenna units and the ground, where the power supply grid supplies power to the photodetector tubes, the number of the photodetector tubes is equal to the number of the antenna units, and output ends of the photodetector tubes are coupled with the antenna units to output radio frequency signals; and
optical waveguides which are disposed in the substrate and connected to the photodetector tubes, wherein the optical waveguides are configured to distribute optical signals to the photodetector tubes.

An embodiment of the present invention further provides a microwave transmitting system, including:
a central office, configured to generate optical difference frequency signals to be transmitted, adjust the optical difference frequency signals to make them on an optical carrier, and transmit the signals to an active optical antenna through an optical fiber; and
the active optical antenna, configured to: through optical waveguides in a substrate of the active optical antenna, distribute optical signals received through the optical fiber to multiple photodetector tubes, where the multiple photodetector tubes convert the received optical difference frequency signals to radio frequency signals, and the radio frequency signals are sent out through antenna units.

An embodiment of the present invention further provides an information sending method, including:
powering on an active optical antenna;
receiving optical signals to be transmitted, and distributing the optical signals to multiple photodetector tubes through optical waveguides in a substrate of the active optical antenna; and
converting, by the multiple photodetector tubes, the received optical signals to radio frequency signals, and sending out the radio frequency signals through antenna units.

By applying the embodiments of the present invention, the optical difference frequency signals are converted to the radio frequency signals by the PD tubes, and the radio frequency signals are sent out through the antenna units coupled with the PD tubes. A PD tube is an active device, which may reach an mw level per unit, and integration of multiple PD tubes avoids a problem that power of a single PD tube is too low. In this way, use of an amplifier is avoided by the integration of the multiple PD tubes, which reduces the cost of the antenna and increases the integration level of the antenna. Furthermore, the signals which are to be transmitted and received by the antenna are optical signals. Therefore, complex optical splitting may be completed by using a planar waveguide technology, so that optical power distribution is completed in an optical domain, which avoids matching and attenuation in an electrical signal distribution network.

In addition, it is convenient for phase control of the optical signals in the optical domain. Therefore, it may be simple and convenient to form an array of phased array antennas. The active optical antenna is connected to the central office through the optical fiber. Therefore, it is convenient for operations such as remote antenna deployment and construction.

### BRIEF DESCRIPTION OF THE DRAWINGS

To illustrate the technical solutions in the embodiments of the present invention and in the prior art more clearly, the following briefly introduces the accompanying drawings required for describing the embodiments and the prior art. Apparently, the accompanying drawings in the following description show merely some embodiments of the present invention, and a person of ordinary skill in the art may still derive other drawings from these accompanying drawings without marking creative efforts.
FIG. 1 is a schematic diagram of a signal transmitting manner in the prior art;
FIG. 2 is a schematic diagram of a main structure of an active optical antenna according to an embodiment of the present invention;
FIG. 3 is a schematic diagram of a sectional structure of the active optical antenna according to the embodiment of the present invention;
FIG. 4 is a schematic diagram of a top structure of the active optical antenna according to the embodiment of the present invention;
FIG. 5 is a schematic structural diagram of a microwave transmitting system according to an embodiment of the present invention; andFIG. 6 is a flow chart of an information sending method according to an embodiment of the present invention.

### DETAILED DESCRIPTION OF THE EMBODIMENTS

The following clearly and completely describes the technical solutions in the embodiments of the present invention with reference to the accompanying drawings in the embodiments of the present invention. Apparently, the described embodiments are merely a part rather than all of the embodiments of the present invention. All other embodiments obtained by a person of ordinary skill in the art based on the embodiments of the present invention without making creative efforts shall fall within the protection scope of the present invention.

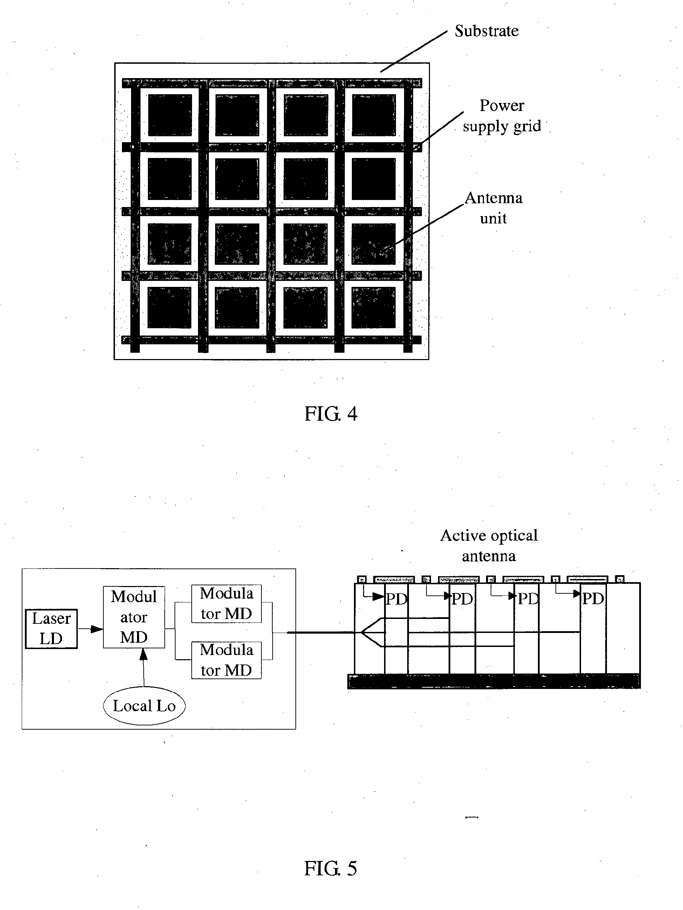

Referring to FIG. 2 to FIG. 4, FIG. 2 is a schematic diagram of a main structure of an active optical antenna according to an embodiment of the present invention, FIG. 3 is a schematic diagram of a sectional structure of the active optical antenna according to the embodiment of the present invention, and FIG. 4 is a schematic diagram of a top structure of the active optical antenna according to the embodiment of the present invention. It may be known in combination with the three drawings that, the active optical antenna provided in the embodiment of the present invention includes:
a substrate;
a ground (Ground) disposed at the bottom of the substrate;
a power supply grid and several antenna units (Patch) that are disposed at the top of the substrate, and photodetector (PD) tubes that are disposed in the substrate and located between the antenna units and the ground, where the power supply grid supplies power to the photodetector tubes, output ends of the photodetector tubes are coupled with the antenna units, and the number of the photodetector tubes is equal to the number of the antenna units; and
optical waveguides which are disposed in the substrate and connected to the photodetector tubes.

The several antenna units are arranged in an array, and the power supply grid is distributed in intervals between the antenna units.

Any semiconductive material that is suitable for making an optical device and meets a requirement of a dielectric constant of an antenna substrate, such as silicon (Si), and indium phosphide (InP), may be selected and used as a substrate. Generally, a relative dielectric constant of Si reaches 11, and the costs of Si are relatively low. The substrate in the embodiment of the present invention is Si.

It should be noted that, because multiple PD tubes are integrated in the Si substrate, each PD tube corresponds to one antenna unit, that is, each PD tube obtains power from the power supply grid and implements power conduction by connecting to the ground, and an output end of each PD tube is coupled with the antenna unit, so that a radio frequency signal that is output is sent out through the antenna unit. In this way, the PD tube converts an optical beat frequency signal to a radio frequency signal, and directly sends the radio frequency signal to the antenna unit for transmission. An array of PD tubes integrated in the Si substrate may adopt a microwave photonic method to implement the conversion of the optical signal to the radio frequency signal. A specific conversion method is completely the same as that in the prior art, which is not repeatedly described here. The array of the integrated PD tubes meets a requirement of transmit power for the radio frequency signal obtained by the conversion performed by the PD tube to directly enter the antenna.

It may be seen that the active optical antenna provided in the embodiment of the present invention is actually a flat-panel display active optical antenna. By applying the antenna provided in the embodiment of the present invention, optical difference frequency signals are converted to radio frequency signals by the PD tubes directly coupled with the antenna units, so that information to be transmitted is sent out. A PD tube is an active device, which may reach an mw level per unit, and integration of multiple PD tubes avoids a problem that the power of a single PD tube is too low. In this way, it is unnecessary to use an amplifier because the multiple PD tubes are integrated, which reduces the costs of the antenna and increases an integration level of the antenna. Furthermore, signals which are to be transmitted and received by the antenna are optical signals. Therefore, complex optical splitting may be completed by using a planar waveguide technology, so that optical power distribution is completed in an optical domain, which avoids matching and attenuation in an electrical signal distribution network.

Referring to FIG. 5, a microwave transmitting system is provided according to an embodiment of the present invention. The the system specifically includes:
a central office, configured to generate optical difference frequency signals to be transmitted, adjust the optical difference frequency signals to make them on an optical carrier, and transmit the signals to an active optical antenna through an optical fiber; and
the active optical antenna, configured to: through optical waveguides in a substrate of the active optical antenna, distribute optical signals received through the optical fiber to multiple photodetector tubes, where the multiple photodetector tubes convert the received optical difference frequency signals to radio frequency signals, and the radio frequency signals are sent out through antenna units. In this way, an array of integrated PD tubes meets a requirement of transmit power for the radio frequency signals obtained by the conversion performed by the PD tubes to directly enter the antenna.

After generating the optical difference frequency signals to be transmitted, the central office is further configured to perform phase adjustment and control on the optical difference frequency signals, so as to adjust a phase of the optical carrier that arrives at each photodetector tube in the active optical antenna, and then adjust the optical difference frequency signals that have undergone the adjustment and control to make them on the optical carrier. A specific phase adjustment and control method is the same as that in the prior art, which is not repeatedly described here.

The active optical antenna may be located at a remote end of the central office, and may also be close to the central office, which may be convenient for deploying the antenna according to an actual need.

By applying the microwave transmitting system provided in the embodiment of the present invention, optical difference frequency signals are converted to radio frequency signals by the PD tubes, and the radio frequency signals are sent out through the antenna units directly coupled with the PD tubes. A PD tube is an active device, which may reach an mw level per unit, and integration of multiple PD tubes avoids a problem that power of a single PD tube is too low. In this way, it is unnecessary to use an amplifier because the multiple PD tubes are integrated, which reduces the costs of the antenna and increases an integration level of the antenna. Furthermore, the signals which are to be transmitted and received by the antenna are optical signals. Therefore, complex optical splitting may be completed by using a planar waveguide technology, so that optical power distribution is completed in an optical domain, which avoids matching and attenuation in an electrical signal distribution network.

In addition, it is convenient for phase control of the optical signals in the optical domain. Therefore, it may be simple and convenient to form an array of phased array antennas. The active optical antenna is connected to the central office through the optical fiber. Therefore, it is convenient for operations such as remote antenna deployment and construction.

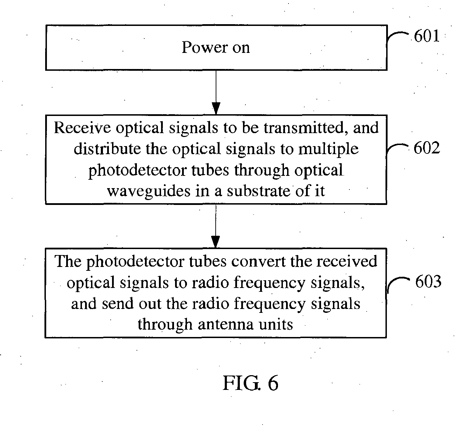

Referring to FIG. 6, it is a flow chart of an information sending method according to an embodiment of the present invention. The method is applied to the foregoing active optical antenna, and may specifically includes:
Step 601: Power on the active optical antenna.
Step 602: Receive optical signals to be transmitted, and distribute the optical signals to multiple photodetector tubes through optical waveguides in a substrate of the active optical antenna.
Step 603: The photodetector tubes convert the received optical signals to radio frequency signals, and send out the radio frequency signals through antenna units.

In this way, an array of integrated PD tubes meets a requirement of transmit power for the radio frequency signals obtained by the convesion performed by the PD tubes to directly enter the antenna.

The received optical signals to be transmitted may have not undergone phase adjustment and control, or may have undergone phase adjustment and control. A specific phase adjustment and control method is the same as that in the prior art, which is not repeatedly described here.

The antenna units are arranged in an array, and power is supplied to the active optical antenna through a power supply grid.

Any semiconductive material that is suitable for making an optical device and meets a requirement of a dielectric constant of an antenna substrate, such as silicon (Si), and indium phosphide (InP), may be selected and used as a substrate. Generally, a relative dielectric constant of Si reaches 11, and the costs of Si are relatively low. The substrate in the embodiment of the present invention is Si.

By applying the information transmitting method provided in the embodiment of the present invention, optical difference frequency signals are converted to radio frequency signals by the PD tubes in the active optical antenna, and the radio frequency signals are sent out through the antenna units directly coupled with the PD tubes. A PD tube is an active device, which may reach an mw level per unit, and integration of multiple PD tubes avoids a problem that power of a single PD tube is too low. In this way, it is unnecessary to use an amplifier because the multiple PD tubes are integrated, which reduces the costs of the antenna and increases an integration level of the antenna. Furthermore, the signals which are to be transmitted and received by the antenna are optical signals. Therefore, complex optical splitting may be completed by using a planar waveguide technology, so that optical power distribution is completed in an optical domain, which avoids matching and attenuation in an electrical signal distribution network.

In addition, it is convenient for phase control of the optical signals in the optical domain. Therefore, it may be simple and convenient to form an array of phased array antennas. The active optical antenna is connected to a central office through an optical fiber. Therefore, it is convenient for operations such as remote antenna deployment and construction.

It should be noted that in the foregoing embodiments, description of each embodiment has its emphasis. Reference may be made to relevant description of another embodiment for the part that is not described in detail in a certain embodiment.

It should be noted that in this application, the terminology "include", "comprise" or any other variant is intended to cover non-exclusive inclusion, so that a process, a method, an object or a device that includes a series of elements not only includes those elements, but also includes other elements that are not explicitly listed, or includes inherent elements of the process, method, object or device. In a case without further limitations, an element limited by the sentence "including one..." does not exclude that another same element may also exist in the process, method, object, or device which includes the elements.

The foregoing descriptions are merely exemplary embodiments of the present invention, but are not intended to limit the protection scope of the present invention. Any modification, equivalent replacement, and improvement made within the spirit and principle of the present invention shall all fall within the protection scope of the present invention.

## Claims

1. An active optical antenna, comprising:
a substrate;
a ground disposed at the bottom of the substrate;
a power supply grid and several antenna units that are disposed at the top of the substrate, and photodetector tubes that are disposed in the substrate and located between the antenna units and the ground, wherein the power supply grid supplies power to the photodetector tubes, the number of the photodetector tubes is equal to the number of the antenna units, and output ends of the photodetector tubes are coupled with the antenna units to output radio frequency signals; and
optical waveguides which are disposed in the substrate and connected to the photodetector tubes, wherein the optical waveguides are configured to distribute optical signals to the photodetector tubes.

2. The active optical antenna according to claim 1, wherein the several antenna units are arranged in an array, and the power supply grid is distributed in intervals between the antenna units.

3. The active optical antenna according to claim 1, wherein the substrate is any semiconductive material that is suitable for making an optical device and meets a requirement of a dielectric constant of an antenna substrate.

4. A microwave transmitting system, comprising a central office and an active optical antenna according any one of claims 1 to 3, wherein the central office is configured to generate optical difference frequency signals to be transmitted, adjust the optical difference frequency signals to make them on an optical carrier, and transmit the signals to the active optical antenna through an optical fiber.

5. The microwave transmitting system according to claim 4, wherein after generating the optical difference frequency signals to be transmitted, the central office is further configured to perform phase adjustment and control on the optical difference frequency signals, so as to adjust a phase of the optical carrier that arrives at each photodetector tube in the active optical antenna, and then adjust the optical difference frequency signals that have undergone the adjustment and control to make them on the optical carrier.

6. The microwave transmitting system according to claim 4 or 5, wherein the active optical antenna is located at a remote end of the central office.

7. An information sending method, comprising:
powering on an active optical antenna (601);
receiving optical signals to be transmitted, and distributing the optical signals to multiple photodetector tubes through optical waveguides in a substrate of the active optical antenna (602); and
converting, by the multiple photodetector tubes, the received optical signals to radio frequency signals, and sending out the radio frequency signals through antenna units (603).

8. The method according to claim 7, wherein the received optical signals to be transmitted may have not undergone phase adjustment and control, or may have undergone phase adjustment and control.

9. The method according to claim 7, wherein the antenna units are arranged in an array.

10. The method according to claim 7, wherein the substrate is any semiconductive material that is suitable for making an optical device and meets a requirement of a dielectric constant of an antenna substrate.

## Patentansprüche

1. Aktive optische Antenne, umfassend:
ein Substrat;
eine Erde, die unten am Substrat angeordnet ist;
ein Energieversorgungsnetz und mehrere Antenneneinheiten, die oben am Substrat angeordnet sind, und Fotodetektorröhren, die in dem Substrat angeordnet und zwischen den Antenneneinheiten und der Erde platziert sind, wobei das Energieversorgungsnetz Energie an die Fotodetektorröhren liefert, die Anzahl der Fotodetektorröhren gleich der Anzahl der Antenneneinheiten ist und die Ausgangsenden der Fotodetektorröhren mit den Antenneneinheiten verbunden sind, um Hochfrequenzsignale auszugeben; und
Lichtwellenleiter, die in dem Substrat angeordnet und mit den Fotodetektorröhren verbunden sind, wobei die Lichtwellenleiter dafür ausgelegt sind, optische Signale an die Fotodetektorröhren zu verteilen.

2. Aktive optische Antenne nach Anspruch 1, wobei die mehreren Antenneneinheiten in einer Gruppe angeordnet sind und das Energieversorgungsnetz in Abständen zwischen den Antenneneinheiten verteilt ist.

3. Aktive optische Antenne nach Anspruch 1, wobei das Substrat ein beliebiges halbleitendes Material ist, das geeignet ist zum Herstellen einer optischen Vorrichtung und eine Anforderung an eine dielektrische Konstante eines Antennensubstrats erfüllt.

4. Mikrowellenübertragungssystem, umfassend eine Vermittlungsstelle und eine aktive optische Antenne nach einem der Ansprüche 1 bis 3, wobei die Vermittlungsstelle dafür ausgelegt ist, zu übertragende optische Differenzfrequenzsignale zu erzeugen, die optischen Differenzfrequenzsignale so anzupassen, dass sie auf einem optischen Träger erzeugt werden, und die Signale über eine Glasfaser an die aktive optische Antenne zu übertragen.

5. Mikrowellenübertragungssystem nach Anspruch 4, wobei nach dem Erzeugen der zu übertragenden optischen Differenzfrequenzsignale die Vermittlungsstelle ferner dafür ausgelegt ist, eine Phaseneinstellung und -regelung an den optischen Differenzfrequenzsignalen auszuführen, um eine Phase des optischen Trägers einzustellen, die bei jeder Fotodetektorröhre in der aktiven optischen Antenne ankommt, und anschließend die optischen Differenzfrequenzsignale anzupassen, die der Einstellung und Regelung unterzogen wurden, um sie auf dem optischen Träger zu erzeugen.

6. Mikrowellenübertragungssystem nach Anspruch 4 oder 5, wobei die aktive optische Antenne an einem entfernten Ende der Vermittlungsstelle platziert ist.

7. Informationssendeverfahren, umfassend:
Anschalten einer aktiven optischen Antenne (601);
Empfangen von zu übertragenden optischen Signalen und Verteilen der optischen Signale an mehrere Fotodetektorröhren über Lichtwellenleiter in einem Substrat der aktiven optischen Antenne (602); und
Umwandeln, durch die mehreren Fotodetektorröhren, der empfangenen optischen Signale in Hochfrequenzsignale und Aussenden der Hochfrequenzsignale durch Antenneneinheiten (603).

8. Verfahren nach Anspruch 7, wobei die empfangenen, zu übertragenden optischen Signale möglicherweise nicht der Phaseneinstellung und -regelung unterzogen wurden oder möglicherweise der Phaseneinstellung und -regelung unterzogen wurden.

9. Verfahren nach Anspruch 7, wobei die Antenneneinheiten in einer Gruppe angeordnet sind.

10. Verfahren nach Anspruch 7, wobei das Substrat ein beliebiges halbleitendes Material ist, das geeignet ist zum Herstellen einer optischen Vorrichtung und eine Anforderung an eine dielektrische Konstante eines Antennensubstrats erfüllt.

## Revendications

1. Antenne optique active comprenant :
un substrat ;
une terre disposée au fond du substrat ;
un réseau d'alimentation électrique et plusieurs unités d'antenne disposés sur le haut du substrat, et des tubes photo-détecteurs qui sont disposés dans le substrat et sont situés entre les unités d'antenne et la terre, le réseau d'alimentation électrique alimentant les tubes photo-détecteurs, le nombre de tubes photo-détecteurs étant égal au nombre d'unités d'antenne, et les extrémités de sortie des tubes photo-détecteurs étant couplées aux unités d'antenne afin d'émettre des signaux radiofréquence ; et
des guides d'onde optiques qui sont disposés dans le substrat et qui sont connectés aux tubes photo-détecteurs, lesquels guides d'onde optiques sont conçus pour distribuer des signaux optiques vers les tubes photo-détecteurs.

2. Antenne optique active selon la revendication 1, dans laquelle plusieurs unités d'antenne sont disposées en un réseau, et le réseau d'alimentation électrique est distribué en intervalles entre les unités d'antenne.

3. Antenne optique active selon la revendication 1, dans laquelle le substrat est fait d'un quelconque matériau semi-conducteur convenant pour fabriquer un dispositif optique et répondant à une exigence de constante diélectrique d'un substrat d'antenne.

4. Système de transmission par micro-ondes comprenant un office central et une antenne optique active selon l'une quelconque des revendications 1 à 3, dans lequel l'office central est conçu pour générer des signaux de fréquence de différence optique à transmettre, ajuster les signaux de fréquence de différence optique pour les faire passer sur une porteuse optique, et transmettre les signaux vers l'antenne optique active via une fibre optique.

5. Système de transmission par micro-ondes selon la revendication 4, dans lequel, après avoir généré les signaux de fréquence de différence optique à transmettre, l'office central est en outre conçu pour effectuer un ajustement et une commande de phase sur les signaux de fréquence de différence optique de manière à ajuster une phase de la porteuse optique qui arrive à chaque tube photo-détecteur dans l'antenne optique active puis ajuster les signaux de fréquence de différence optique qui ont subi l'ajustement et la commande afin de les faire passer sur la porteuse optique.

6. Système de transmission par micro-ondes selon les revendications 4 ou 5, dans lequel l'antenne optique active se situe à une extrémité distante de l'office central.

7. Procédé d'envoi d'informations consistant à :
mettre sous alimentation une antenne optique active (601) ;
recevoir des signaux optiques à transmettre et distribuer les signaux optiques vers de multiples tubes photo-détecteurs via les guides d'onde optique dans un substrat de l'antenne optique active (602) ; et
convertir, à l'aide des multiples tubes photo-détecteurs, les signaux optiques reçus en signaux radiofréquence et envoyer les signaux radiofréquence via les unités d'antenne (603).

8. Procédé selon la revendication 7, dans lequel les signaux optiques reçus à transmettre peuvent ne pas avoir subi d'ajustement ni de commande de phase, ou avoir subi un ajustement et une commande de phase.

9. Procédé selon la revendication 7, dans lequel les unités d'antenne sont disposées en réseau.

10. Procédé selon la revendication 7, dans lequel le substrat est fait d'un quelconque matériau semi-conducteur convenant pour fabriquer un dispositif optique et répondant à une exigence de constante diélectrique d'un substrat d'antenne.
